**Europäisches Patentamt**

(19) **European Patent Office**

**Office européen des brevets**

(11) Publication number : **0 455 360 B1**

(12) **EUROPEAN PATENT SPECIFICATION**

(45) Date of publication of patent specification : **22.11.95 Bulletin 95/47**

(51) Int. Cl.$^6$ : **H01L 31/18, H01L 21/20, H01L 31/068**

(21) Application number : **91303176.1**

(22) Date of filing : **10.04.91**

(54) **Method of manufacturing a solar cell.**

(30) Priority : **13.04.90 JP 98802/90**

(43) Date of publication of application : **06.11.91 Bulletin 91/45**

(45) Publication of the grant of the patent : **22.11.95 Bulletin 95/47**

(84) Designated Contracting States : **DE FR GB**

(56) References cited :
EP-A- 0 328 405
PATENT ABSTRACTS OF JAPAN vol. 13, no. 38 (E-709)(3386) 27 January 1989, & JP-A- 63 236308
PATENT ABSTRACTS OF JAPAN vol. 11, no. 70 (E-485)(2517) 03 March 1987, & JP-A- 61 225816
CONFERENCE RECORD OF THE 19th IEEE PHOTOVOLTAIC SPECIALISTS CONFERENCE 04 May 1987, NEW-ORLEANS, LOUISIANA, US pages 338 - 344; T.O'HARA ET AL.: "HIGH EFFICIENCY GaAs SOLAR CELLS FABRICATED ON Si SUBSTRATES"
PATENT ABSTRACTS OF JAPAN vol. 13, no. 307 (E-787) 13 July 1989, & JP-A- 01 082572
PATENT ABSTRACTS OF JAPAN vol. 13, no. 272 (E-777) 22 June 1989, & JP-A- 01 061958
APPLIED PHYSICS LETTERS. vol. 55, no. 21, 20 November 1989, NEW YORK US pages 2187 - 2189; A.ACKAERT ET AL.: "CRACK FORMATION AND THERMAL STRESS RELAXATION OF GaAs ON Si GROWTH BY METALORGANIC VAPOR PHASE EPITAXY"
PATENT ABSTRACTS OF JAPAN vol. 13, no. 181 (E-750) 27 April 1989, & JP-A- 01 008612
PATENT ABSTRACTS OF JAPAN vol. 12, no. 500 (E-699)(3347) 27 December 1988, & JP-A-63 211774
PATENT ABSTRACTS OF JAPAN vol. 13, no. 139 (E-738) 06 April 1989, & JP-A- 63 302576

(73) Proprietor : **MITSUBISHI DENKI KABUSHIKI KAISHA**
**2-3, Marunouchi 2-chome**
**Chiyoda-ku**
**Tokyo (JP)**
Proprietor : **NIPPON TELEGRAPH AND TELEPHONE CORPORATION**
**1-6 Uchisaiwaicho 1-chome**
**Chiyoda-ku**
**Tokyo (JP)**

(72) Inventor : **Oohara, Takahiko**
**11-12, Hagiyama 4-chome**
**Higashimurayama-shi, Tokyo (JP)**
Inventor : **Ohmachi, Yoshiro**
**703-1, Tateno 2-chome**
**Higashiyamato-shi, Tokyo (JP)**
Inventor : **Kadota, Yoshiaki**
**545-1, Kawaraguchi**
**Ebina-shi, Kanagawa-ken (JP)**
Inventor : **Mitsui, Kotaro, c/o Mitsubishi Denki K.K.**
**Optelectr. and Microwave Devices R & D Lab.**
**1 Mizuhara 4-chome, Itami-shi, Hyogo-ken (JP)**
Inventor : **Ogasawara, Nobuyoshi, c/o Mitsubishi Denki K.K.**
**Optelectr. and Microwave Devices R & D Lab.**
**1 Mizuhara 4-chome, Itami-shi, Hyogo-ken (JP)**
Inventor : **Nishimura, Takashi, c/o Mitsubishi Denki K.K.**
**Optelectr. and Microwave Devices R & D Lab.**
**1 Mizuhara 4-chome, Itami-shi, Hyogo-ken (JP)**

(74) Representative : **Beresford, Keith Denis Lewis et al**
**BERESFORD & Co.**
**2-5 Warwick Court**
**High Holborn**
**London WC1R 5DJ (GB)**

## Description

FIELD OF THE INVENTION

The present invention relates to a method for manufacturing a GaAs solar cell on a Si substrate.

BACKGROUNDS OF THE INVENTION

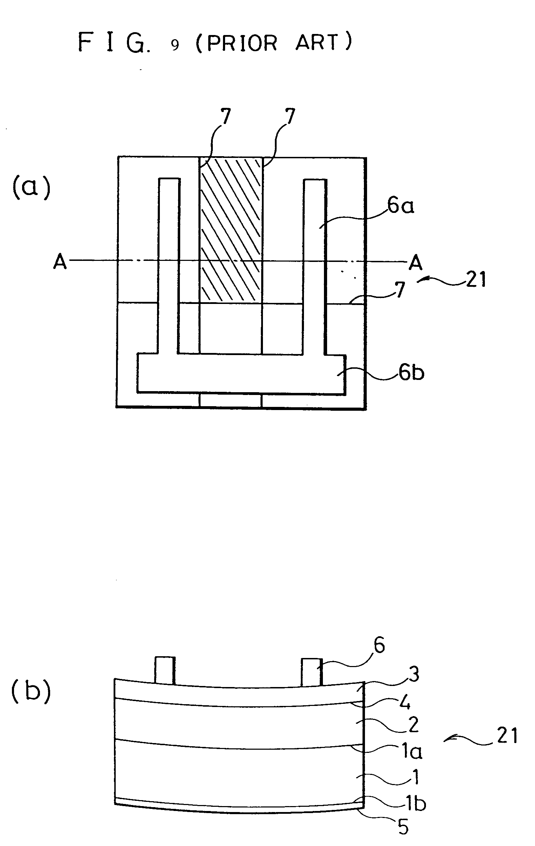

Figures 9(a) & (b) are views showing a structure of a conventional GaAs solar cell on an Si substrate, in which figure 9(a) is its plan view and figure 9 (b) is a sectional view taken along a line A-A in figure 9(a). In figure 9, reference numeral 1 designates an Si substrate. An n type GaAs layer 2 and a p type GaAs layer 3 which serve as active layers are laminated on a first main surface 1a of the Si substrate 1 and then an anode electrode (p type electrode) 6 is formed on the p type GaAs layer 3 and a cathode electrode (n type electrode) 5 is provided on a second main surface 1b of the Si substrate 1. Thus, a solar cell 21 is formed.

The GaAs solar cell 21 on the Si substrate is normally manufactured by the following method.

First, the n type GaAs layer 2 and the p type GaAs layer 3 are sequentially formed on the first main surface 1a of the n type Si substrate 1 having a surface orientation of approximately (100) by a method of crystal growth of a compound semiconductor, such as MOCVD method. Thus, a pn junction 4 which generates a photovoltaic effect is formed. Then, as an electrode for taking a photoelectromotive force out, the anode electrode (p side electrode) 6 is selectively formed on the p type GaAs and the cathode electrode (n side electrode) 5 is formed on the whole surface of the second main surface 1b of the Si substrate 1. The anode electrode 6 comprises collecting electrodes 6a for collecting a photoelectric current and a common electrode 6b for connecting the collecting electrodes to an outside circuit. In addition, these electrodes are formed by sputtering or a vapour deposition method and Ti/Ag is normally used as their materials.

However, the conventional GaAs solar cell on the Si substrate has the following problems. That is, since the n type GaAs layer 2 and the p type GaAs layer 3 are usually formed at a high temperature of 700 to 800°C, when a wafer on which the above GaAs layers are formed is taken out at a room temperature, a large warpage is generated because of a difference in thermal expansion coefficient between GaAs and Si as shown in figure 9(b).As the thickness of the GaAs layer is increased, the degree of this warpage becomes large. When the thickness of the GaAs layer exceeds 3μm, a crack is generated. On the other hand, as the thickness of the GaAs layer is increased, dislocation density in the GaAs layer is reduced. Therefore, in order to assure sufficient performance of the solar cell, the thickness should be 4 to 5μm. Thus, the crack is generated in the operation layer (active layer) of the conventional solar cell. Particularly, a region surrounded by a crack 7 on which the collecting electrode 6a is not provided, which region is shown by slanting lines in figure 9(a), is a loss region because the generated photoelectric current cannot be collected.

In addition, even if no crack is generated, at the outset, since considerably large thermal stress remains in the GaAs layer, when slight stress is applied from the outside, a crack is easily generated in the GaAs layer. Since warpage is concave when the GaAs layer is on the upper side as shown in figure 9 (b), a crack is easily generated when a stress is applied from the direction of the second main surface 1b of the Si substrate, that is, when a tensile stress is applied to the GaAs layer. Therefore, when the wafer is flattened in a photolithography process for Patterning the p type electrode 6 or when interconnector welding for modulation is performed on the first electrode 5 side in the assembling process, a crack is obviously generated.

Japanese Kokai 63-236308 has addressed the problem of wafer warpage and cracking. As a solution to this problem there is proposed a method in which a silicon nitride film is grown on the rear surface of the silicon substrate at a low temperature of the order of 300°C by plasma CVD, thermal CVD or sputtering. The silicon substrate is plastically deformed convexly on the substrate side when the substrate is heated to a temperature equal to or higher than approximately 800°C. Then the silicon nitride film is removed and a compound semiconductor layer of GaAs is grown by MOCVD while the substrate is still plastically deformed and maintained at a temperature of between 600 and 750°C. The substrate is then cooled to room temperature.

Japanese Kokai 61-225816 has also addressed the problem of reducing wafer warpage. An auxiliary layer of material having a coefficient of thermal expansion similar to that of a gallium arsenide active layer is first formed on the rear surface of the silicon substrate at a temperature which is the same as that for forming the gallium arsenide active layer.

The present invention is intended as a solution to the problems aforesaid.

In accordance with the present invention there is provided a method of manufacturing a gallium arsenide on silicon solar cell, which method comprises:

providing a silicon substrate having front and rear surfaces;

depositing on the rear surface of said substrate a layer of material of lower thermal expansion coefficient than silicon;

raising the temperature of said substrate so that the front surface thereof becomes convex;

growing on the convex front surface of said substrate successive first and second layers of gallium arsenide, which layers are doped p or n-type and n or p-type respectively; and

causing said substrate and successive first and second layers to cool to room temperature;

which method is characterised in that:

the step of depositing said layer of material is performed at a temperature at or close to room temperature;

the thickness of said layer of material deposited is such that upon performing the step of raising the temperature of said substrate, the substrate is deformed elastically to produce said convex front surface; and

the respective thickness of the grown first and second layers, the substrate, and the deposited layer of material, are such that upon said cooling to room temperature the substrate is substantially flat and said first and second layers are substantially free of residual thermal stress.

The layer formed of the material having a thermal expansion coefficient smaller than that of the Si substrate warps the Si substrate into a convex shape at a temperature when the GaAs layer is formed, that is, a stress is generated on the first main surface of the Si substrate. As a result, residual stress of the GaAs layer can be reduced and also a degree of its warpage can be reduced at the room temperature after the GaAs layer is formed.

Conveniently, a layer comprising a conductive material having a thermal expansion coefficient smaller than that of Si can be formed on the second main surface of the Si substrate at a temperature close to the room temperature before the first and second GaAs layers of the first and second conductivity types, which serve as the active layers, are formed on the first main surface of the first conductivity type Si substrate. This can be used as an electrode.

Optionally, a GaAs buffer layer to which a first conductivity type impurity of high concentration is applied can be formed on the first main surface of the first conductivity type Si substrate before the layer comprising a material having a thermal expansion coefficient smaller than that of the Si substrate is formed on the second main surface of the Si substrate at a temperature close to the room temperature and the first and second GaAs layers of first and second conductivity types are sequentially formed on the buffer layer. As a result, an active layer can be formed on a clean surface of the Si substrate having no thermal stress.

## BRIEF DESCRIPTION OF THE DRAWINGS

Figures 1(a) to (d) are sectional views showing a method for manufacturing a GaAs solar cell on an Si substrate in accordance with a first embodiment of the present invention;

Figure 2(a) is a plan view showing the GaAs solar cell on the Si substrate obtained by the manufacturing method shown in figure 1 and figure 2(b) is a sectional view taken along a line A-A in figure 2(a);

Figure 3 is a view showing a warpage at a raised temperature in the step shown in figure 1(b);

Figure 4 is a sectional view showing a GaAs solar cell on an Si substrate in accordance with a second embodiment of the present invention;

Figures 5(a) to (d) are sectional views showing a method for manufacturing a GaAs solar cell on an Si substrate in accordance with a third embodiment of the present invention;

Figures 6(a) to (e) are views showing a method for manufacturing a GaAs solar cell on an Si substrate in accordance with a variation of the third embodiment of the present invention;

Figure 7 is an enlarged view in the vicinity of a mesa part in the step shown in figure 6(d);

Figure 8 is an enlarged view in the vicinity of the mesa part in the step shown in figure 6(e); and

Figures 9(a) & (b) are plan and cross-section views showing a conventional GaAs solar cell on an Si substrate.

## DETAILED DESCRIPTION OF THE PREFERRED EMBODIMENT

Embodiments of the present invention will be described hereinbelow with reference to the drawings aforesaid.

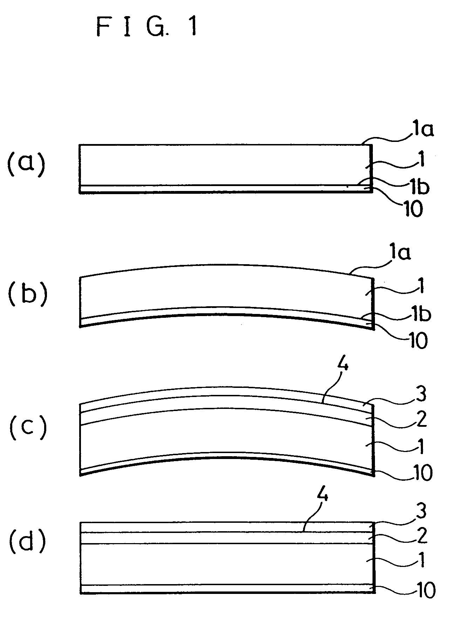

Figures 1(a) to (d) are sectional views showing a method for manufacturing a solar cell in accordance with a first embodiment of the present invention. In figure 1, reference numeral 1 designates an n type Si substrate, reference numeral 1a designates a first main surface of the Si substrate 1, reference numeral 1b designates a second main surface opposite to the first main surface 1a. An n type GaAs layer 2 is arranged on the first main surface 1a of the Si substrate 1. A p type GaAs layer 3 is arranged on the n type GaAs layer 2. A, pn junction 4 is formed between the n type GaAs layer 2 and the p type GaAs layer 3. Reference numeral 10 designates an auxiliary layer comprising a material having a thermal expansion coefficient smaller than that of Si, which is formed on the second main surface of the Si substrate 1.

Next, the manufacturing steps will be described.

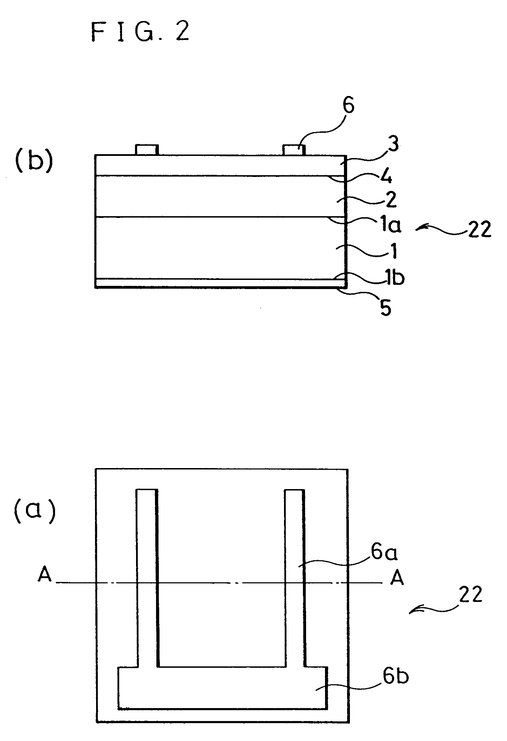

First, the auxiliary layer 10 comprising a material having a thermal expansion coefficient smaller than that of Si is formed on the second main surface 1b of the n type Si substrate 1 of a (100) surface whose surface orientation is inclined by 2 degrees in the <111> direction at a temperature close to the room temperature as shown in figure 1(a). As a material of this auxiliary layer 10, boron nitride (BN), carbon (C), silicon dioxide ($SiO_2$) or the like is used. The auxiliary layer 10 is formed by sputtering or a photo-assisted chemical vapor deposition. Their thermal expansion coefficients are $1.0 \times 10^{-6}$, $1.7 \times 10^{-6}$, $5 \times 10^{-7}$ [1/° C] which are smaller than $2.4 \times 10^{-6}$ [1/° C] which is a thermal expansion coefficient of Si. When the wafer is heated up at a temperature when the GaAs layer is formed such as approximately 700°C, the Si substrate is warped into a convex shape as shown in figure 1(b) because of the difference in thermal expansion coefficient between the materials of Si and the auxiliary layer 10. In this state, the n type GaAs layer 2 and the p type GaAs layer 3 are formed by an MOCVD method, MBE method or the like as shown in figure 1(c). Thereafter, when the wafer is taken out of a crystal growing apparatus at the room temperature, an epitaxial wafer which is not warped and has no residual stress in the GaAs layer can be provided as shown in figure 1(d). The GaAs solar cell 22 on the Si substrate shown in figure 2 can be formed using the above epitaxial wafer by the room method for manufacturing the solar cell. In figure 2, reference numeral 5 designates an n side electrode which is formed on the second main surface of the Si substrate by vapour deposition, sputtering, plating method or the like using a metal material such as Ti/Au after the layer 10 having a thermal expansion coefficient smaller than that of Si is removed. In addition, reference numeral 6 designates a p side electrode which is selectively formed on a part of the surface of the p type GaAs layer 3 by photolithography or the like so that light may be input into the pn junction 4 which generates photoelectromotive force. The p side electrode 6 comprises collecting electrodes 6a for collecting a photoelectric current and a common electrode 6b for connecting the collecting electrode 6a to the outside circuit. The p side electrode 6 may be formed using the same material and method as those of the n side electrode 5.

As described above, since a flat epitaxial wafer can be formed in accordance with the first embodiment of the present invention, it is not necessary to apply stress from the outside to flatten the wafer in the step of photolithography which requires flatness or the step of grinding the back surface for adjusting the thickness while the solar cell is manufactured. As a result, crack generation is prevented in the GaAs layers 2 and 3. In addition, since it is also not necessary to apply stress from the outside to flatten the wafer at the time of interconnecting to the electrodes 5 and 6 in an assembling step for modulation, again crack generation is prevented.

In addition, since an epitaxial wafer having no residual stress can be provided in the first embodiment of the present invention, accidental crack generation is prevented although force is applied from the outside during the manufacturing steps.

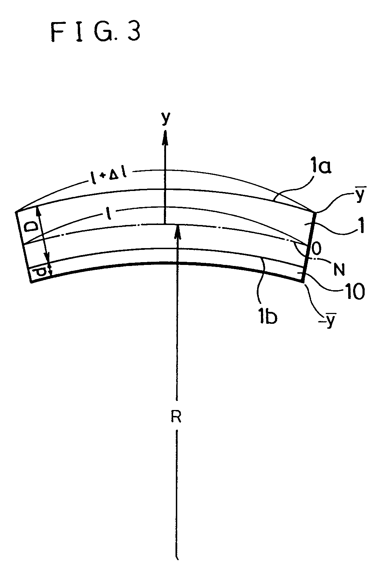

Next, a design of a thickness of the auxiliary layer 10 in which BN is used as a material which has a thermal expansion coefficient smaller than that of Si in accordance with the first embodiment of the present invention will be described with reference to figure 3. Figure 3 is a schematic view showing a state of the wafer shown in figure 1(b). In figure 3, reference character R designates a radius of curvature of warpage and reference character D designates a thickness of the Si substrate and reference character d designates a thickness of BN formed at the room temperature. The warpage caused by thermal stress $\sigma$ is obtained as follows.

$$\frac{1}{R} = \frac{6d\,(1 - \nu_{Si})}{D^2 E_{Si}} \sigma \quad (1)$$

where $E_{Si}$ and $\nu_{Si}$ are Young's modulus and Poissons ratio, respectively. A neutral surface N of strain and stress exists in the wafer and its position is obtained as follows.

$$Y = \frac{D}{2} \frac{1 + 2t}{1 + et} \quad (2)$$

where t = d/D,

$$e = (\frac{E_{BN}}{1 - \nu_{BN}}) / (\frac{E_{Si}}{1 - \nu_{Si}})$$

and $E_{BN}$ and $\nu_{BN}$ are Young's modulus and Poissons ratio of BN, respectively.

When a length of the wafer before deformation is shown by $\ell$, extension $\Delta\ell$ on the surface la is as follows.

$$\Delta \frac{Y}{R} \ell \quad (3)$$

More specifically, when BN is formed on the back surface 1b of the Si substrate at the room temperature and then heated up at the GaAs growing temperature, the 1a surface of the Si substrate on which GaAs is to be grown up is extended to $\ell +\Delta\ell$. The thickness d of the BN should be determined so that the following equation may be implemented, that is,

$$\frac{\Delta\ell}{\ell} = \alpha GaAs\Delta T \quad (4)$$

where $\alpha GaAs$ is the thermal expansion coefficient of GaAs and $\Delta T$ is a temperature difference. Meanwhile, when the thermal expansion coefficients of Si and BN are shown by $\alpha_{Si}$ and $\alpha_{BN}$, respectively since $\sigma = E_{BN}(\alpha_{BN} - \alpha_{Si})\Delta T / (1 - \nu_{BN})$,

$$d = [\{\alpha_{GaAs} - 3(\alpha_{Si} - \alpha_{BN})\} e - \sqrt{\{\alpha_{GaAs} - 3(\alpha_{Si} - \alpha_{BN})\}^2 e^2 - 24\alpha_{GaAs}(\alpha_{Si} - \alpha_{BN})e]} \times D/12(\alpha_{Si} - \alpha_{BN})e$$

in view of the above equations (1), (2), (3) and (4).

When respective values are substituted, the thickness of BN is approximately 38μm and the thickness of the Si substrate is 100μm.

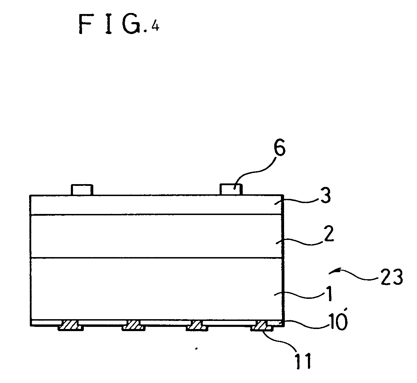

Next, a second embodiment of the present invention will be described. Although the n electrode is formed on the second main surface 1b of the Si substrate after the layer 10 comprising a material whose thermal expansion coefficient is smaller than that of Si is removed in the above first embodiment of the present invention, a conductive material may be used as a material whose thermal expansion coefficient is smaller than that of Si, which serves as the n type electrode as it is in the second embodiment of the present invention. As this material, a BN film to which carbon is applied in high concentration may be used. This is formed by a reactive sputtering method using acetylene as reactive gas or photo-assisted chemical vapour deposition using diborane and ammonia as main gases and acetylene as doping gas in which a BN sintered body is used as a target. When resistivity of the Si substrate is high, contact resistance between BN and Si becomes high. However, in this case, it is possible to reduce the contact resistance by selectively forming through holes on the BN film 10′ and forming a metal electrode 11 comprising a material such as Ti/Au on the exposed second main surface of the Si substrate as shown in figure 4. In addition, an interconnecting part for modulation may be formed on the metal electrode 11. In this case, welding of the interconnector or the like can be performed on the metal electrode 11 more easily than on the BN film 10′.

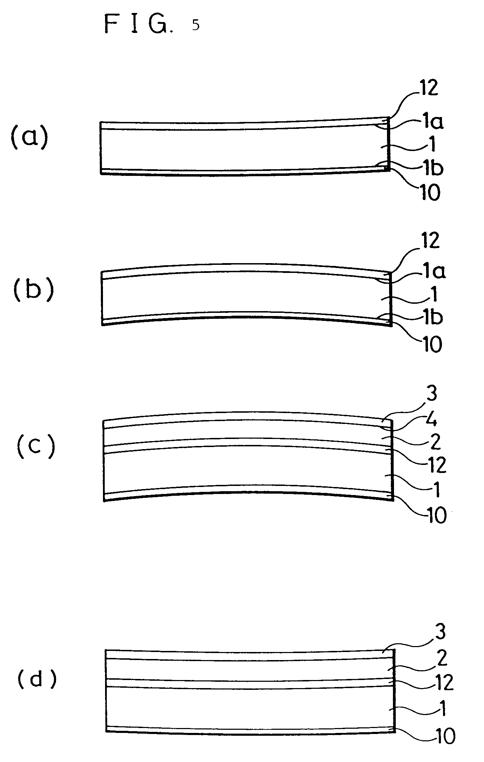

Next, a third embodiment of the present invention will be described. Figures 5(a) to (d) are sectional views showing a method for manufacturing a solar cell in accordance with the third embodiment of the present invention. In figure 5, the same references as in figure 1 designate the same or corresponding parts and reference numeral 12 designates an n$^+$ GaAs buffer layer.

Next, its manufacturing steps will be described. First, referring to figure 5(a), a n$^+$ GaAs layer 12 having a thickness of approximately 2μm is formed on the first main surface 1a of the Si substrate 1. Then, the BN film 10 is formed at the room temperature. In this case, unlike figure 1, the substrate is warped a little by thermal stress of the n$^+$ GaAs layer. However, when the thickness of the n$^+$ GaAs layer is 2μm or less, the degree of warpage can be disregarded. Then, referring to figure 5(b), when the wafer is heated up at a temperature when the GaAs layer is grown, it is warped like in figure 1(b). However, in this case the degree of warpage is smaller than that shown in figure 1(b) because of the n$^+$ GaAs layer. Then, referring to figure 5(c), then type GaAs layer 2 and the p type GaAs layer 3 which are necessary for the solar cell are formed and then the wafer is taken out at the room temperature. Then, referring to figure 5(d), the degree of warpage can be considerably reduced as compared with a conventional example where there is no BN film. According to the third embodiment of the present invention, although the warpage is generated a little, there are the following advantages as compared with the first embodiment of the present invention. When the GaAs layer is formed on the Si substrate in general, it is necessary to clean the surface of the Si substrate at a high temperature of 900 to 1000°C before the GaAs layer is grown thereon. When a foreign material such as BN is formed on the second main surface of the Si substrate, the first main surface of the Si substrate is polluted at the above high temperature processing, with the result that epitaxial growth of GaAs is not uniformly implemented. According to the embodiment shown in figure 5, when the GaAs layer is formed on the.Si substrate, GaAs can be epitaxially grown on the clean Si substrate having no foreign material, so that a uniform grown layer is obtained. Thereafter, when the GaAs layer is formed at a temperature of 700 to 800°C after the BN is formed at the room temperature, because the n$^+$ GaAs layer 12 is already formed, homoepitaxial growth can be implemented and then the GaAs layer is uniformly formed in a relatively easy manner. In addition, because it is grown at a considerably low temperature of 900 to 1000°C, the element can be prevented from being polluted by BN.

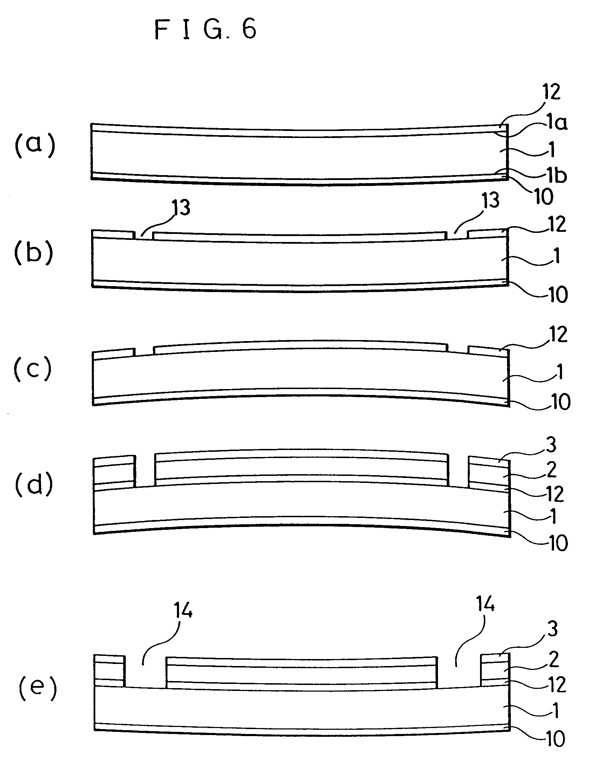

Figure 6 are sectional views showing a method for manufacturing a solar cell in accordance with a variation of the third embodiment of the present invention. In figure 6. the same reference numerals as in figure 5 designate the same or corresponding parts and reference numerals 13 and 14 designate mesa grooves formed in the vicinity of the wafer.

Next, the manufacturing steps will be described hereinafter.

First, referring to figure 6(a), the wafer is formed like in figure 5(a). Then, referring to figure 6(b), the BN film 10 is formed and then the mesa groove 13 is formed by selectively etching the $n^+$ GaAs layer 12 so that a part of the Si substrate surface may be exposed. Then, referring to figure 6(c), the wafer is heated up at 700 to 800°C and then it is warped. Then, referring to figure 6(d), the n type GaAs layer 2 and the p type GaAs layer 3 are formed. In this case, since a natural oxide film is formed on the Si surface which is exposed by the mesa groove, a GaAs crystal is not grown but the GaAs layer is selectively grown thereon. Then, referring to figure 6(e). when the wafer is taken out of the GaAs crystal growing apparatus at the room temperature, the degree of warpage is reduced as compared with that by the conventional method.

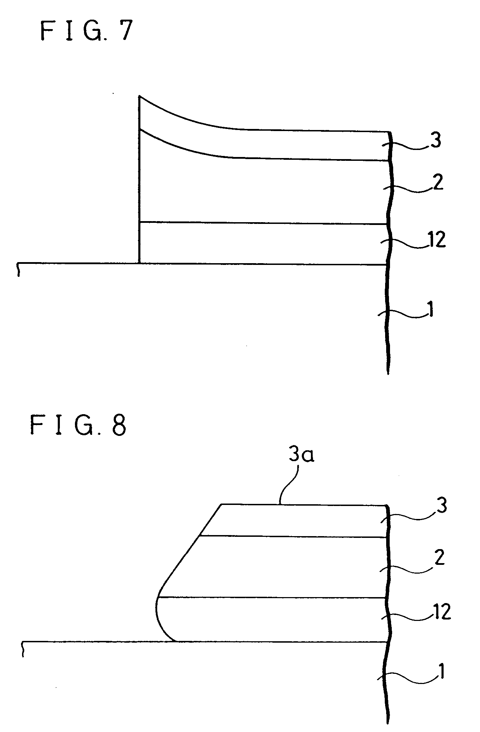

In this variation, the mesa groove 14 whose width is larger than that of the mesa groove 13 is formed by selectivity removing the GaAs layer in the vicinity of the mesa groove 13 formed after the $n^+$ GaAs layer 12 is formed. The reason why the mesa groove 14 is formed is described hereinafter. According to this variation, as described above, the GaAs layer is not grown on the Si substrate surface of the mesa groove in the step shown in figure 6(d). In this GaAs layer growing process, since reactive gas applied to the mesa groove is not deposited on the Si substrate, it is used for GaAs growth in the vicinity of the mesa groove. Therefore, as shown in figure 7, a grown layer becomes thick in the vicinity of the mesa groove and specially its edge part is sharply swollen. Since mechanical stress is concentrated in this swollen part, many cracks are generated from this part. Therefore, the mesa groove 14 shown in figure 6(e) are formed by selectively removing the swollen part.

Figure 8 is a view showing an example of a sectional structure of the GaAs layer in the vicinity of the mesa groove, in which stress concentration in the vicinity of the element can be reduced as much as possible in accordance with the variation of the third embodiment of the present invention. As shown in figure 8, the angle formed between a side surface of the p type GaAs layer 2 and the n type GaAs layer 3 and a p type GaAs layer surface 3a is set at 90° or more to prevent the stress from being concentrated in an acute angle part. This configuration can be easily formed by a method such as forward mesa etching in the GaAs layer having a growing surface in the vicinity of (100) surface. Alternatively, the above structure can be formed by reducing adhesive strength between the photoresist and the GaAs layer in the vicinity of the mesa groove to accelerate etching at an interface between the photoresist and GaAs. In addition, referring to figure 8, since the contact angle formed between the $n^+$ GaAs layer and an interface against the Si substrate is an obtuse angle, the stress is prevented from being concentrated. This configuration can be easily formed by using nature of etchant in which etching speed depends on the stress. More specifically, since the stress is largest at the interface against the Si substrate in the n+ GaAs layer and it becomes smaller as it gets away from that, the configuration shown in figure 8 can be etched away using solution of sulphuric acid, hydrogen peroxide and water as etchant for GaAs.

As described above, a layer comprising a material having a thermal expansion coefficient smaller than that of the Si substrate is formed on the second main surface of the first conductivity type Si substrate at a temperature close to the room temperature and then the first and second GaAs layers of first and second conductivity types which serve as active layers are formed on the first main surface of the Si substrate. As a result, residual stress in the GaAs layer can be reduced and the degree of warpage can be also reduced, so that a more flat epitaxial wafer can be obtained and there is provided a GaAs solar cell on the Si substrate which has no or few cracks.

Provided that before the first and second GaAs layers of the first and second conductivity types which serve as active layers are formed on the first main surface of the first conductivity type Si substrate, a layer comprising a conductive material having a thermal expansion coefficient smaller than that of Si is formed on the second main surface of the Si substrate at a temperature close to the room temperature, then as a result, in addition to the effect obtained as above the steps of removing the auxilliary layer and then forming the first electrode are not necessary and the manufacturing process is simplified. In addition, even if a temperature becomes lower than the room temperature in a thermal shock test or the like, a compressed stress is applied to the GaAs layer, which offsets the residual tensile stress. As a result, crack generation is prevented.

According to a preferred method for manufacturing the GaAs solar cell on the Si substrate of the present invention, the GaAs buffer layer to which an impurity of the first conductivity type of high concentration is applied is formed on the first main surface of the first conductivity type Si substrate and then the layer comprising a material having a thermal expansion coefficient smaller than that of the Si substrate is formed on the second main surface of the substrate at a temperature close to the room temperature and then the first and second GaAs layers of the first and second conductivity types are sequentially formed on the buffer layer. As a result, there can be provided a GaAs active layer which has no thermal stress on the clean Si substrate surface.

Although the present invention has been described and illustrated in detail, it is clearly understood that the same is by way of illustration and example only and is not to be taken by way of limitation, the scope of the present invention being limited only by the terms of the appended claims.

EP 0 455 360 B1

## Claims

1. A method of manufacturing a gallium arsenide on silicon solar cell, which method comprises:
   providing a silicon substrate (1) having front and rear surfaces (1a,1b);
   depositing on the rear surface (1b) of said substrate (1) a layer (10) of material of lower thermal expansion coefficient than silicon;
   raising the temperature of said substrate (1) so that the front surface (1a) thereof becomes convex;
   growing on the convex front surface (1a) of said substrate (1) successive first and second layers (2,3) of gallium arsenide, which layers (2,3) are doped p or n-type and n or p-type respectively; and
   causing said substrate (1) and successive first and second layers (2,3) to cool to room temperature;
   which method is characterised in that:
   the step of depositing said layer (10) of material is performed at a temperature at or close to room temperature;
   the thickness of said layer (10) of material deposited is such that upon performing the step of raising the temperature of said substrate (1), the substrate (1) is deformed elastically to produce said convex front surface (1a); and
   the respective thickness of the grown first and second layers (2,3), the substrate (1), and the deposited layer (10) of material, are such that upon said cooling to room temperature, the substrate (1) is substantially flat and said first and second layers (2,3) are substantially free of residual thermal stress.

2. A method as claimed in claim 1 wherein said step of depositing said layer (10) of material is preceded by a step in which a thin-film layer (12) of gallium arsenide, doped $n^+$ or $p^+$-type respectively, is grown on the front surface (la) of said substrate (1).

3. A method as claimed in either preceding claim wherein following cooling to room temperature said layer (10) of material is replaced by a layer of electrode material.

4. A method as claimed in claim 3 wherein said layer (10) of material comprises silicon oxide, silicon nitride, boron nitride or carbon, or a combination thereof.

5. A method as claimed in either preceding claim 1 or 2 wherein said layer (10) of material is electroconductive and is suitable as an electrode layer.

6. A method as claimed in claim 5 wherein said layer (10) of material comprises boron nitride and includes a high concentration of carbon dopant for enhancing the electroconductivity thereof.

7. A method as claimed in either preceding claim 1 or 2 wherein through-holes are formed in said layer (10) of material and metal electrode material (11) is deposited on the rear surface thereof and said through-holes are filled therewith.

8. A method as claimed in claim 7 wherein said layer (10) of material is of carbon doped boron nitride and said metal electrode material (11) is of titanium and gold.

9. A method as claimed in claim 2 or in any claim depending from claim 2 wherein the thickness of said thin-film layer (12) is 2 um or less.

10. A method as claimed in claim 2 or in any claim depending from claim 2 wherein:
    following growth of said thin-film layer (12) of gallium arsenide but preceding growth of said first and second layers (2,3) there is formed a groove (13) in said thin-film layer (12) exposing the underlying surface (1a) of the silicon substrate (1), and on this exposed surface (1a) a natural oxide is formed; and
    the step of growing said first and second layers (2,3) is performed so that material is grown only on the remanent part of said thin film layer (12).

11. A method as claimed in claim 10 wherein material is removed from the edge portions of said first and second layers (2,3).

12. A method as claimed in claim 11 wherein after removal of said material the angle that is subtended between the edge surface of said first and second layers (2,3) and the front surface (1a) of the substrate

7

(1) is 90° or less.

13. A method as claimed in claim 12 wherein the contact angle that is subtended at the interface between the thin-film layer (12) and the front surface (1a) of the substrate (1) is 90° or more and the angle subtended between the edge surface of said thin-film layers (12) and said first and second layers (2,3) and the front surface (1a) of said substrate (1) is a continuous gradually decreasing function of distance from said front surface (1a) of the substrate (1).

## Patentansprüche

1. Ein Verfahren zur Herstellung einer Galliumarsenidauf-Solarzelle, wobei das Verfahren aufweist:
   Bereitstellen eines Siliziumsubstrates (1) mit vorden und rückwärtigen Obeflächen (1a, 1b);
   Abscheiden einer Schicht (10) eines Materiales von geringerem thermischen Ausdehnungskoeffizienten als Silizium auf der rückwärtigen Oberfläche (1b) des Substrates (1);
   Anheben der Temperatur des Substrates (1), so daß die vordere Oberfläche (1a) hiervon konvex wird;
   Aufeinanderfolgendes Aufwachsen erster und zweiter Schichten (2, 3) von Galliumarsenid auf der konvexen vorderen Oberfläche (1a) des Substrates (1), wobei die Schichten (2, 3) p- oder n-dotiert bzw. n- oder p-dotiert sind; und
   Abkühlenlassen des Substrates (1) und der aufeinanderfolgenden ersten und zweiten Schichten (2, 3) auf Raumtemperatur;
   wobei das Verfahren dadurch gekennzeichnet ist, daß:
   der Schritt des Abscheidens der Schicht (10) des Materiales bei einer Temperatur bei oder nahe bei Raumtemperatur durchgeführt wird;
   die Dicke der Schicht (10) des abgeschiedenen Materiales so ist, daß beim Durchführen des Schrittes des Anhebens der Temperatur des Substrates (1) das Substrat (1) elastisch deformiert wird, um die konvexe vordere Oberfläche (1a) zu erzeugen; und
   die jeweiligen Dicken der aufgewachsenen ersten und zweiten Schichten (2, 3), des Substrates (1) und der abgeschiedenen Schicht (10) des Materiales so sind, daß bei Abkühlen auf Raumtemperatur das Substrat (1) im wesentlichen flach ist und die ersten und zweiten Schichten (2, 3) im wesentlichen frei von verbleibenden thermischen Belastungen sind.

2. Ein Verfahren nach Anspruch 1, wobei dem Schritt des Abscheidens der Schicht (10) des Materials ein Schritt vorausgeht, in dem eine Dünnfilmschicht (12) aus Galliumarsenid, welches $n^+$- oder $p^+$-dotiert ist auf der vorderen Oberfläche (1a) des Substrates (1) aufgewachsen wird.

3. Ein Verfahren nach einem der vorhergehenden Ansprüche, wobei nach dem Abkühlen auf Raumtemperatur die Schicht (10) des Materials durch eine Schicht des Elektrodenmaterials ersetzt wird.

4. Ein Verfahren nach Anspruch 3, wobei die Schicht (10) des Materiales Siliziumoxid, Siliziumnitrid, Bornitrid, Kohlenstoff, oder eine Kombination hiervon aufweist.

5. Ein Verfahren nach einem der vorhergehenden Ansprüche 1 oder 2, wobei die Schicht (10) des Materiales elektrisch leitfähig ist und als Elektrodenschicht geeignet ist.

6. Ein Verfahren nach Anspruch 5, wobei die Schicht (10) des Materiales Bornitrid aufweist und eine hohe Konzentration von Kohlenstoff-Dotiermittel zur Verbesserung der elektrischen Leitfähigkeit beinhaltet.

7. Ein Verfahren nach einem der vorhergehenden Ansprüche 1 oder 2, wobei Durchgangsbohrungen in der Schicht (10) des Materiales gebildet werden und metallisches Elektrodenmaterial (11) an der rückwärtigen Oberfläche hiervon abgeschieden wird und die Durchgangsbohrungen hiermit gefüllt werden.

8. Ein Verfahren nach Anspruch 7, wobei die Schicht (10) des Materiales kohlenstoffdotiertes Bornitrid ist und das metallische Elektrodenmaterial (11) aus Titan und Gold ist.

9. Ein Verfahren nach Anspruch 2 oder einem Anspruch, der von Anspruch 2 abhängig ist, wobei die Dicke der Dünnfilmschichten (12) 2 µm oder weniger beträgt.

**10.** Ein Verfahren nach Anspruch 2, oder irgend einem Anspruch, der vom Anspruch 2 abhängt, bei dem:
nach dem Aufwachsen der Dünnfilmschicht (12) aus Galliumarsenid aber vor dem Aufwachsen der ersten und zweiten Schichten (2, 3) eine Ausnehmung (13) in der Dünnfilmschicht (12) gebildet wird, welche die darunter liegende Oberfläche (1a) des Siliziumsubstrates (1) freilegt, wobei auf dieser freiliegenden Oberfläche (1a) ein natürliches Oxid gebildet wird; und
der Schritt des Aufwachsens der ersten und zweiten Schichten (2, 3) so durchgeführt wird, daß das Material nur auf dem verbleibenden Teil der Dünnfilmschicht (12) aufgewachsen wird.

**11.** Ein Verfahren nach Anspruch 10, wobei Material von den Kantenbereichen der ersten und zweiten Schichten (2, 3) entfernt wird.

**12.** Ein Verfahren nach Anspruch 11, wobei nach dem Entfernen des Materiales der Winkel, der zwischen der Kantenoberfläche der ersten und zweiten Schichten (2, 3) und der vorderen Oberfläche (1a) des Substrates (1) eingeschlossen ist, 90° oder weniger beträgt.

**13.** Ein Verfahren nach Anspruch 12, wobei der Kontaktwinkel, der an der Schnittstelle der Dünnfilmschicht (12) und der vorderen Oberfläche (1) des Substrates (1) eingeschlossen wird, 90° oder mehr beträgt und der Winkel, der zwischen der Kantenoberfläche der Dünnfilmschichten (12) und der ersten und zweiten Schichten (2, 3) und der vorderen Oberfläche (1a) des Substrates (1) eingeschlossen ist, eine kontinuierlich graduell abnehmende Funktion des Abstandes von der vorderen Oberfläche (1a) des Substrates (1) ist.

**Revendications**

**1.** Méthode de fabrication d'une cellule solaire en arseniure de gallium ou en silicium, laquelle méthode consiste à :
prévoir un substrat en silicium (1) ayant des surfaces avant et arrière (1a, 1b) ;
déposer, sur la surface arrière (1b) dudit substrat, une couche (10) en un matériau de plus faible coefficient de dilatation thermique que le silicium ;
élever la température dudit substrat (1) de manière que sa surface avant (1a) devienne convexe ;
faire croître sur la surface avant convexe (1a) dudit substrat (1) des première et seconde couches (2, 3) en arseniure de gallium, lesquelles couches (2, 3) sont dopées, respectivement, du type p ou n et du type n ou p ; et
forcer ledit substrat (1) et les première et seconde couches successives (2, 3) à refroidir à température ambiante; et
laquelle méthode est caractérisée en ce que :
l'étape de déposer ladite couche (10) du matériau est accomplie à une température à ou proche de la température ambiante ;
l'épaisseur de ladite couche (10) de matériau déposée est telle que lorsque l'on accomplit l'étape d'élever la température dudit substrat (1), le substrat (1) est déformé élastiquement pour produire ladite surface avant convexe (1a) ; et
l'épaisseur respective des première et seconde couches tirées (2, 3), du substrat (1) et de la couche déposée (10) de matériau sont telles que, lors dudit refroidissement à température ambiante, le substrat (1) soit sensiblement plat et lesdites première et seconde couches (2, 3) soient sensiblement exemptes de tout effort thermique résiduel.

**2.** Méthode selon la revendication 1, où ladite étape de déposer ladite couche (10) du matériau est précédée par une étape dans laquelle une couche en film mince (12) d'arseniure de gallium, respectivement dopé du type $n^+$ ou $p^+$, est tirée à la surface avant (1a) dudit substrat (1).

**3.** Méthode selon toute revendication précédente où, à la suite du refroidissement à température ambiante, ladite couche (10) de matériau est remplacée par une couche d'un matériau d'électrode.

**4.** Méthode selon la revendication 3, où ladite couche (10) de matériau comprend de l'oxyde de silicium, du nitrure de silicium, du nitrure de bore ou du carbone ou bien une association de ceux-ci.

**5.** Méthode selon toute revendication 1 ou 2 qui précède où ladite couche (10) de matériau est électroconductrice et est appropriée comme couche d'électrode.

6.  Méthode selon la revendication 5, où ladite couche (10) de matériau comprend du nitrure de bore qui comporte une forte concentration de carbone dopant pour améliorer son électroconductivité.

7.  Méthode selon toute revendication 1 ou 2 qui précède où des trous sont formés dans ladite couche (10) de matériau et un matériau d'électrode en métal (11) est déposé sur sa surface arrière et lesdits trous en sont remplis.

8.  Méthode selon la revendication 7, où ladite couche de matériau est en nitrure de bore dopé de carbone et ledit matériau d'électrode de métal (11) est en titane et or.

9.  Méthode selon la revendication 2 ou selon toute revendication dépendant de la revendication 2, où l'épaisseur de ladite couche en film mince (12) est de 2 $\mu$m ou moins.

10. Méthode selon la revendication 2 ou selon toute revendication dépendant de la revendication 2 où :
    à la suite de la croissance de ladite couche en film mince (12) d'arséniure de gallium mais avant la croissance desdites première et seconde couches (2, 3), on forme une gorge (13) dans ladite couche (12) en film mince exposant la surface sous-jacente (1a) du substrat en silicium (1) et sur cette surface exposée (1a) est formé un oxyde naturel ; et
    l'étape de croissance des première et seconde couches (2,3) est accomplie de manière que le matériau ne croisse que sur la partie rémanente de ladite couche en film mince (12).

11. Méthode selon la revendication 10, où le matériau est retiré des portions des bords desdites première et seconde couches (2, 3).

12. Méthode selon la revendication 11, où après avoir retiré ledit matériau, l'angle qui est sous-tendu entre la surface du bord desdites première et seconde couches (2,3) et la surface avant (1a) du substrat (1) est de 90° ou moins.

13. Méthode selon la revendication 12, où l'angle de contact qui est sous-tendu à l'interface entre la couche en film mince (12) et la surface avant (1a) du substrat (1) est de 90° ou plus et l'angle sous-tendu entre la surface du bord desdites couches (12) en film mince et lesdites première et seconde couches (2, 3) et la surface avant (1a) dudit substrat (1) est une fonction graduellement décroissante de la distance de ladite surface avant (1a) dudit substrat 1.

F I G. 1

(a)

1a
1
1b
10

(b)

1a
1
1b
10

(c)

4
3
2
1
10

(d)

4
3
2
1
10

FIG. 2

(b)

(a)

# F I G. 3

F I G.4

F I G. 5

(a)

12
1a
1
1b
10

(b)

12
1a
1
1b
10

(c)

3
4
2
12
1
10

(d)

3
2
12
1
10

F I G. 6

(a)

(b)

(c)

(d)

(e)

F I G. 7

F I G. 8

## F I G. 9 (PRIOR ART)

(a)

(b)